(19) Europäisches Patentamt / European Patent Office / Office européen des brevets

(11) **EP 3 317 903 B1**

(12) **EUROPÄISCHE PATENTSCHRIFT**

(45) Veröffentlichungstag und Bekanntmachung des Hinweises auf die Patenterteilung:
**29.05.2024 Patentblatt 2024/22**

(21) Anmeldenummer: **16756943.3**

(22) Anmeldetag: **10.08.2016**

(51) Internationale Patentklassifikation (IPC):
**H10N 60/01** (2023.01)   **H10N 60/20** (2023.01)
**H01B 12/02** (2006.01)

(52) Gemeinsame Patentklassifikation (CPC):
**H10N 60/203; H10N 60/0801**

(86) Internationale Anmeldenummer:
**PCT/EP2016/001369**

(87) Internationale Veröffentlichungsnummer:
**WO 2017/025190 (16.02.2017 Gazette 2017/07)**

(54) **VERFAHREN UND VORRICHTUNG ZUR HERSTELLUNG EINES SUPRALEITFÄHIGEN LEITERS**

METHOD AND DEVICE FOR PRODUCING A SUPERCONDUCTIVE CONDUCTOR

PROCÉDÉ ET DISPOSITIF DE FABRICATION D'UN CONDUCTEUR SUPRACONDUCTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.08.2015 DE 102015010676**

(43) Veröffentlichungstag der Anmeldung:
**09.05.2018 Patentblatt 2018/19**

(73) Patentinhaber: **Karlsruher Institut für Technologie**
**76131 Karlsruhe (DE)**

(72) Erfinder:
• **FIETZ, Walter**
  **76344 Eggenstein-Leopoldshafen (DE)**
• **WOLF, Michael J.**
  **75177 Pforzheim (DE)**
• **HELLER, Reinhard**
  **76887 Bad Bergzabern (DE)**
• **WEISS, Klaus-Peter**
  **76297 Stutensee (DE)**

(74) Vertreter: **Müller-Boré & Partner**
**Patentanwälte PartG mbB**
**Friedenheimer Brücke 21**
**80639 München (DE)**

(56) Entgegenhaltungen:
**WO-A1-2010/042259    JP-A- 2002 270 422**
**JP-A- 2010 033 821    JP-A- 2010 044 969**
**KR-A- 20070 093 702    US-A- 5 299 728**

• **WOLF MICHAEL J ET AL: "HTS CroCo: A Stacked HTS Conductor Optimized for High Currents and Long-Length Production", IEEE TRANSACTIONS ON APPLIED SUPERCONDUCTIVITY, IEEE SERVICE CENTER, LOS ALAMITOS, CA, US, Bd. 26, Nr. 2, 1. März 2016 (2016-03-01), Seiten 19-24, XP011608745, ISSN: 1051-8223, DOI: 10.1109/TASC.2016.2521323 [gefunden am 2016-03-01]**

EP 3 317 903 B1

**Beschreibung**

Die Erfindung betrifft ein Verfahren und eine Vorrichtung zur Herstellung eines supraleitfähigen Leiters.

Supraleiter sind Materialien, deren elektrischer Widerstand unterhalb einer bestimmten Temperatur komplett verschwindet. Folglich haben Supraleiter keine elektrischen DC-Verluste, sofern sie bei genügend tiefen Temperaturen betrieben werden. Ein Leiter für den Stromtransport oder eine Spule aus solchen supraleitenden Materialien weist folglich keine DC-Verluste auf. Somit kann ein Strom über solch einen Leiter sehr effektiv übertragen werden. Insbesondere können mit supraleitenden Magneten hohe Magnetfelder sehr effizient erzeugt werden. Man unterscheidet Tieftemperatur- und Hochtemperatursupraleiter nach dem Wert der Temperatur des Phasenübergangs vom supraleitenden zum normalleitenden Zustand. Bei Tieftemperatursupraleitern liegt dieser typischerweise unter 30 K, bei Hochtemperatursupraleitern zum Teil sehr deutlich höher, z.B. über der Siedetemperatur des Stickstoffs (T = -196°C). Daher werden Hochtemperatur-Supraleiter (HTS) auch für weitergehende Anwendungen diskutiert, da - im Vergleich zu Tieftemperatursupraleitern - der Aufwand für die Kühlung deutlich reduziert ist. Dazu zählen u.a. die Energieübertragung, rotierende Maschinen, wie z.B. Generatoren, Motoren, etc., oder Magnete, z.B. für NMR oder Teilchenbeschleuniger.

Hochtemperatursupraleiter aus Seltenerd-Barium-Kupfer-Oxid-Materialien (engl. Rare Earth Barium Copper Oxide, kurz REBCO), sind im Hinblick auf die Feld- und Temperaturbereiche sowie auf die Stromdichte die derzeit auf dem Markt erhältlichen interessantesten HTS-Materialien. Allerdings werden diese in Form von dünnen Bändern hergestellt, bei denen der Supraleiter als dünne Schicht mit einer Dicke von ungefähr 1 $\mu$m auf ein Substrat aufgebracht wird, so dass ein Band mit einer typischen Dicke von 100 $\mu$m bei einer Breite im Millimeter-Bereich entsteht. Für diese flachen Bänder können keine klassischen Verseilungstechniken zur Herstellung von Kabeln hoher Stromtragfähigkeit angewandt werden, so dass neue Ansätze benötigt werden um aus den Supraleiterbändern elektrische Leiter bzw. Kabel für höhere Ströme zu fertigen.

Bei der Übertragung hoher elektrischer Leistungen durch Supraleiter müssen die Leiter entsprechend gekühlt werden. Insofern ist es wünschenswert, das zu kühlende Volumen möglichst klein zu halten, also hohe Stromdichten im Bündel bzw. Kabel zu erzielen. Eine hohe Leistungsdichte ist auch bei der Erzeugung hoher Felder in großen Magneten gewünscht. Gleichzeitig ist eine hohe mechanische Stabilität der Kabel nötig, z.B. im Hinblick auf mechanische Abstützung mit möglichst geringem Wärmeeintrag, thermischen Zyklen oder elektromagnetische Kräften.

Die Druckschrift KR 10 2007 0093702 A offenbart eine Vorrichtung und ein Verfahren zum Verbinden eines mit einer Stabilisierungsschicht beschichteten Leiters mit einem Leiter, der mit einer supraleitfähigen Schicht beschichtet ist. Dabei wird geschmolzenes Lötmittel direkt auf eine Verbindungsfläche eines der beschichteten Leiter aufgesprüht.

Die Druckschrift WO 2010/042259 A offenbart ein supraleitfähiges Kabel, welches aus einem Stapel von supraleitfähigen Bändern gebildet ist, wobei der Stapel bezüglich einer longitudinalen Achse des Stapels eine Verdrillung aufweist.

Die Druckschrift JP 2010-044969 A offenbart ein Verfahren zur Erzeugung eines supraleitenden REBCO-Bands.

Die Druckschrift JP 2002-270422 A offenbart ein supraleitendes Kabel, bei dem mit Hilfe einer Barriere das Eindringen einer Kühlflüssigkeit verhindert werden soll. Die Barriere kann z.B. durch das Aufbringen einer Lötmittel-Schicht auf das supraleitende Kabel mit Hilfe eines Lötbads ausgebildet werden.

Die Druckschrift US 5 299 728 A offenbart eine Vorrichtung und ein Verfahren zum Ausbilden eines laminierten supraleitenden Bandes durch Führen von drei Folien über Umlenkrollen durch ein Lötbad und Walzen der drei Folien mit einer Andruckrolle.

Es ist eine Aufgabe der vorliegenden Erfindung, ein Verfahren und eine Vorrichtung zur Herstellung eines kompakten, mechanisch stabilen und für hohe Stromdichten ausgelegten supraleitfähigen Leiters bereitzustellen.

Diese Aufgabe wird durch die Gegenstände der nebengeordneten Ansprüche gelöst. Vorteilhafte Ausführungsformen sind Gegenstand der Unteransprüche.

Ein erster unabhängiger Aspekt zur Lösung der Aufgabe betrifft ein Verfahren zur Herstellung eines supraleitfähigen Leiters, umfassend die folgenden Schritte, insbesondere in der angegebenen Reihenfolge:

- Bereitstellen einer Vielzahl von leitfähigen Bändern mit Hilfe einer Bandbereitstellungseinrichtung, wobei die Vielzahl von leitfähigen Bändern zumindest ein Supraleiterband umfasst;
- Aufbringen von flüssigem Lötmittel auf die Vielzahl von leitfähigen Bändern durch Eintauchen der leitfähigen Bänder in ein Lötbad;
- Ausbilden eines Bandstapels durch Stapeln der mit Lötmittel benetzten leitfähigen Bänder in dem Lötbad;
- Ausbilden eines Supraleiterkörpers durch Bearbeiten des Bandstapels mit Hilfe eines Walzensystems;

wobei das Lötbad einen Eingang mit einer Vielzahl von kammartig angeordneten Einzeleingängen für die Vielzahl von leitfähigen Bändern, einen Durchgang zum Stapeln der Vielzahl von leitfähigen Bändern, und einen Ausgang aufweist.

Unter einem leitfähigen bzw. elektrisch leitfähigen Band wird allgemein ein flaches, elektrisch leitfähiges Band verstanden, welches beispielsweise eine Dicke von etwa 100 $\mu$m und z.B. eine Breite von etwa 2 mm bis 12 mm aufweist.

Die Länge eines leitfähigen Bandes kann je nach Anwendung z.B. 1 m bis 1 km oder auch mehr betragen. Ein leitfähiges Band kann insbesondere ein Metallband, wie z.B. ein Kupferband sein. Mit anderen Worten kann das leitfähige Band teilweise oder vollständig aus Metall, wie z.B. Kupfer gebildet sein. Ein leitfähiges Band kann aber auch supraleitfähig sein. Mit anderen Worten kann ein leitfähiges Band ein Supraleiterband sein.

Ein Supraleiterband ist ein Band, welches ein Substrat umfasst, auf das ein Supraleiter, insbesondere ein Hochtemperatur-Supraleiter wie z.B. REBCO, als dünne Schicht, beispielsweise mit einer Dicke von etwa 1 μm, aufgebracht ist. Das Substrat kann z.B. eine Dicke von etwa 100 μm aufweisen. Ein Supraleiterband hat somit beispielsweise ebenfalls eine Dicke von etwa 100 μm und kann z.B. eine Breite von etwa 2 mm bis 12 mm aufweisen. Die Länge eines Supraleiterbands kann je nach Anwendung z.B. 1 m bis 1 km oder auch mehr sein. Es versteht sich, dass aber auch andere Werte möglich sind. Bei den ersten und zweiten Supraleiterbändern handelt es sich vorzugsweise um Hochtemperatur-Supraleiterbänder.

Unter flüssigem Lötmittel wird insbesondere heißes bzw. geschmolzenes Lötmittel verstanden, d.h. Lötmittel, welches über seine Schmelztemperatur erhitzt wurde bzw. ist. Bei Raumtemperatur oder darunter, d.h. nach dem Abkühlen, ist das Lötmittel dagegen in einem festen Aggregatszustand. Die ersten und zweiten Supraleiterbänder werden erfindungsgemäß jeweils mit flüssigem bzw. heißem bzw. geschmolzenem Lötmittel benetzt bzw. belotet.

Anschließend werden die mit flüssigem Lötmittel benetzten leitfähigen Leiter mit Hilfe einer Stapelerzeugungseinrichtung gestapelt bzw. zu einem Stapel oder Bandstapel angeordnet. Das Stapeln umfasst insbesondere ein Anordnen, Ausrichten und/oder Orientieren der mit flüssigem Lötmittel benetzten ersten und zweiten Supraleiterbänder.

Schließlich wird ein, insbesondere einstückiger, Supraleiterkörper ausgebildet, indem der Bandstapel mit Hilfe eines Walzensystems bearbeitet wird. Das Bearbeiten umfasst insbesondere ein Formen, Fixieren, Pressen und/oder Walzen. Durch das Bearbeiten bzw. Walzen des Bandstapels werden die einzelnen leitfähigen Bänder mechanisch und elektrisch miteinander verbunden bzw. zusammengefügt. Insbesondere werden die leitfähigen Bänder miteinander verlötet, indem während des Walzvorgangs das Lötmittel abkühlt und sich verfestigt. Durch das Abkühlen und Verfestigen des Lötmittels werden jeweils aufeinanderfolgende leitfähige Bänder fest miteinander verbunden. Die verlöteten Bänder bzw. der verlötete Supraleiter-Bandstapel bilden bzw. bildet den Supraleiterkörper.

Als Lötmittel wird vorzugsweise ein Weichlot wie z.B. PbSn, In, In-Sn, In-Bi, Sn-Ag, etc. verwendet.

In einer bevorzugten Ausführungsform umfasst das Bereitstellen einer Vielzahl von leitfähigen Bändern ein Bereitstellen einer Vielzahl von ersten leitfähigen Bändern, welche jeweils eine erste Breite aufweisen, und einer Vielzahl von zweiten leitfähigen Bändern, welche jeweils eine zweite Breite aufweisen, wobei sich die erste Breite von der zweiten Breite unterscheidet. Das Stapeln der mit Lötmittel benetzten leitfähigen Bänder erfolgt vorzugsweise derart, dass aus den ersten und zweiten leitfähigen Bändern ein Bandstapel mit kreuzförmigem Querschnitt gebildet wird.

Insbesondere umfasst das Verfahren die folgenden Schritte:

- Bereitstellen einer Vielzahl von ersten Supraleiterbändern, welche jeweils eine erste Breite aufweisen, und einer Vielzahl von zweiten Supraleiterbändern, welche jeweils eine zweite Breite aufweisen, mit Hilfe einer Supraleiterbandbereitstellungseinrichtung, wobei sich die erste Breite von der zweiten Breite unterscheidet;
- Aufbringen von flüssigem Lötmittel auf die ersten und zweiten Supraleiterbänder mit Hilfe einer Belotungseinrichtung;
- Stapeln der mit Lötmittel benetzten ersten und zweiten Supraleiterbänder mit Hilfe einer Stapelerzeugungseinrichtung derart, dass aus den ersten und zweiten Supraleiterbändern ein Bandstapel mit kreuzförmigem Querschnitt gebildet wird;
- Ausbilden eines Supraleiterkörpers durch Bearbeiten des Bandstapels mit Hilfe eines Walzensystems.

Vorzugsweise werden eine Vielzahl von ersten Supraleiterbändern und eine Vielzahl von zweiten Supraleiterbändern bereitgestellt, wobei sich jeweils ein erstes Supraleiterband von einem zweiten Supraleiterband in der Breite des Supraleiterbandes unterscheidet. Vorzugsweise werden ausschließlich erste Supraleiterbänder mit einer ersten Breite und zweite Supraleiterbänder mit einer zweiten Breite bereitgestellt, d.h. es werden vorzugsweise keine Supraleiterbänder mit anderen Breiten als die erste und zweite Breite bereitgestellt. Insbesondere ist die erste Breite größer als die zweite Breite.

In einer weiteren bevorzugten Ausführungsform umfasst das Verfahren vor dem Aufbringen von flüssigem Lötmittel vorzugsweise ein Reinigen der leitfähigen Bänder, insbesondere der ersten und zweiten leitfähigen Bänder, und/oder ein Aufbringen von Flussmittel auf die leitfähigen Bänder, insbesondere auf die ersten und zweiten leitfähigen Bänder, mit Hilfe einer Belotungsvorbereitungseinrichtung.

Die Belotungsvorbereitungseinrichtung umfasst vorzugsweise einen oder mehrere mit Reinigungsmittel und/oder mit Flussmittel getränkte Schwämme. Die Schwämme sind dabei derart angeordnet, dass die leitfähigen Bänder an den Schwämmen abgestreift werden. Auf diese Weise werden die leitfähigen Bänder vorteilhafterweise von Verschmutzungen und/oder Oxidation befreit und für das anschließende Beloten vorbereitet. Durch das Aufbringen von Flussmittel wird insbesondere die Haftung des Lötmittels auf den leitfähigen Bändern unterstützt.

In einer weiteren bevorzugten Ausführungsform erfolgt das Bearbeiten des Bandstapels zu einem Zeitpunkt, zu dem das auf die leitfähigen Bänder aufgebrachte Lötmittel in einem flüssigen Zustand ist. Vorzugsweise erfolgt das Bearbeiten unmittelbar nach dem Aufbringen des Lötmittels, d.h. während dem Abkühlen und Erhärten des Lötmittels. In dieser Zeitspanne sind die einzelnen leitfähigen Bänder noch flexibel bzw. gegeneinander verschiebbar, so dass sich auf diese Weise der Bandstapel einfacher und besser formen lässt. Insbesondere lässt sich der Bandstapel in einfacher und formschlüssiger Weise verdrillen. Alternativ kann das Bearbeiten auch nach einem erneuten Erhitzen des Bandstapels, insbesondere über die Schmelztemperatur des Lötmittels, erfolgen.

In einer weiteren bevorzugten Ausführungsform umfasst das Bearbeiten des Bandstapels ein Verdrillen des Bandstapels. Das Verdrillen erfolgt vorzugsweise mit Hilfe von gegeneinander verdrehten Walzen bzw. Walzeinheiten des Walzensystems, wobei die Länge einer vollständigen (360°) Verdrehung, d.h. die sogenannte Schlaglänge oder der Twist-Pitch, durch den Abstand der einzelnen Walzeinheiten und/oder durch den relativen Verdrehwinkel der einzelnen Walzeinheiten eingestellt wird. Mit anderen Worten kann die Schlaglänge des Leiters und/oder Bandstapels und/oder Supraleiterkörpers bzw. die Schlaglänge des Kabels über den Abstand bzw. über Abstände der einzelnen Walzeinheiten und/oder über den oder die relativen Verdrehwinkel der einzelnen Walzeinheiten eingestellt werden.

Eine Verdrillung des Bandstapels bzw. des Supraleiterkörpers ist vor allem dann wünschenswert, wenn durch den supraleitfähigen Leiter Ströme mit einem Wechselstrom-Anteil fließen sollen. Weiter ist eine Verdrillung vorteilhaft, falls der Leiter wie zum Beispiel beim Wickeln eines Magneten gebogen werden muss. In diesem Falle würde ohne Verdrillung ein außen liegendes Band des Leiters stark gedehnt und ein inneres Band des Leiters stark komprimiert werden. Wird der Leiter jedoch verdrillt, so wechseln sich Dehnung und Komprimierung zyklisch ab.

Im Vergleich zu herkömmlichen Verfahren, bei denen eine Verdrillung erst nach der Herstellung des Leiters vorgenommen wird, erfolgt die Verdrillung des Leiters vorzugsweise noch während der Herstellung des Leiters oder durch erneutes Erhitzen über die Schmelztemperatur des Lötmittels, d.h. zu einem Zeitpunkt, zu dem das verwendete Lötmittel zum Verlöten der einzelnen leitfähigen Bänder noch bzw. wieder flüssig ist. Somit kann im Vergleich zu den herkömmlichen Verfahren vorteilhafterweise lokaler Stress und damit eine Degradierung des Leiters reduziert oder vermieden werden. Insbesondere können dadurch die Stromtrageigenschaften des Leiters verbessert werden.

In einer weiteren bevorzugten Ausführungsform umfasst das erfindungsgemäße Verfahren ein Anordnen bzw. Einführen des Supraleiterkörpers in ein Hüllrohr, z.B. ein Kupferrohr, wobei das Anordnen bzw. Einführen des Supraleiterkörpers in das Hüllrohr vorzugsweise ein Integrieren, d.h. Anordnen, Einlegen bzw. Einfügen, von einem oder mehreren leitfähigen Formstücken, insbesondere Drähten, z.B. aus Kupfer, umfasst.

Vorteilhafterweise können bei dem erfindungsgemäßen Verfahren Standard-Teile, z.B. Kupferrohre in einfach erhältlichen Normgrößen, als Hüllrohre zum Einsatz kommen. Dies führt zu einer deutlichen Kostenreduktion verglichen mit anderen Ansätzen. Das Hüllrohr weist vorzugsweise einen runden Querschnitt auf.

In einer weiteren bevorzugten Ausführungsform des erfindungsgemäßen Verfahrens wird vor dem Einführen des Supraleiterkörpers in das Hüllrohr der Supraleiterkörper mit Lot, z.B. einem Lötdraht bzw. Lötband, und/oder einem Metalldraht, insbesondere aus Kupfer, Aluminium und/oder Messing und/oder einem Stahlband und/oder einem Isoliermaterial bzw. Isolierband, z.B. aus Kapton, umwickelt.

In einer weiteren bevorzugten Ausführungsform des erfindungsgemäßen Verfahrens wird vor dem Einführen des Supraleiterkörpers in das Hüllrohr der Supraleiterkörper mit Lot, z.B. einem Lötdraht bzw. Lötband, umwickelt und anschließend der Supraleiterkörper und/oder das Hüllrohr zum mechanischen und/oder elektrischen Verbinden bzw. Zusammenfügen bzw. Fixieren des Supraleiterkörpers mit dem Hüllrohr auf zumindest die Schmelztemperatur des Lotes erwärmt. Durch Aufheizen des Lotes über seine Schmelztemperatur ist es möglich, das Hüllrohr und den Supraleiterkörper miteinander zu verlöten. Dadurch kann eine mechanisch stabile und gut elektrisch leitfähige Verbindung zwischen Supraleiterkörper und Hüllrohr realisiert werden.

In einer weiteren bevorzugten Ausführungsform umfasst das erfindungsgemäße Verfahren ferner ein Kompaktieren des mit dem Supraleiterkörper gefüllten Hüllrohres.

Das Kompaktieren umfasst Verformungstechniken wie z.B. ein Rundkneten oder Hämmern. Durch das Kompaktieren wird der Querschnitt des Hüllrohres so weit verringert, bis dieses eng am Supraleiterkörper anliegt, wobei die gegebenenfalls eingebrachten Drähte und/oder Bänder die Kräfte auf den Supraleiterkörper bzw. die leitfähigen Bänder reduzieren und diesen/diese dadurch vor Beschädigungen schützen.

Ein weiterer unabhängiger Aspekt zur Lösung der Aufgabe betrifft eine Vorrichtung zur Herstellung eines supraleitfähigen Leiters, umfassend:

- eine Bandbereitstellungseinrichtung zur Bereitstellung einer Vielzahl von leitfähigen Bändern;
- ein Lötbad zum Aufbringen von flüssigem Lötmittel auf die Vielzahl von leitfähigen Bändern, in das die leitfähigen Bänder getaucht und mit Lötmittel benetzt werden können, wobei das Lötbad ferner als eine Stapelerzeugungseinrichtung zum Ausbilden eines Bandstapels durch Stapeln der mit flüssigem Lötmittel benetzten leitfähigen Bänder ausgelegt ist;
- ein Walzensystem zum Bearbeiten des Bandstapels und Ausbilden eines Supraleiterkörpers, und wobei das Lötbad einen Eingang mit einer Vielzahl von kammartig angeordneten Einzeleingängen für die Vielzahl von leitfähigen Bändern, einen Durchgang zum Stapeln der Vielzahl von leitfähigen Bändern, sowie einen Ausgang aufweist.

Die Belotungseinrichtung kann auch Teil der Stapelerzeugungseinrichtung sein. Mit anderen Worten kann die Stapelerzeugungseinrichtung die Belotungseinrichtung umfassen. Das Lötbad ist insbesondere elektrisch beheizbar.

In einer weiteren bevorzugten Ausführungsform umfasst die Bandbereitstellungseinrichtung eine Vielzahl von ersten Spulen zum Bereitstellen einer Vielzahl von ersten leitfähigen Bändern, welche jeweils eine erste Breite aufweisen und eine Vielzahl von zweiten Spulen zum Bereitstellen einer Vielzahl von zweiten leitfähigen Bändern, welche jeweils eine zweite Breite aufweisen, wobei sich die erste Breite von der zweiten Breite unterscheidet. Die Vielzahl von ersten leitfähigen Bändern und/oder die Vielzahl von zweiten leitfähigen Bändern umfasst zumindest ein Supraleiterband. Mit anderen Worten umfasst die Bandbereitstellungseinrichtung insbesondere zumindest eine Spule zum Bereitstellen zumindest eines Supraleiterbandes.

Die leitfähigen Bänder bzw. Supraleiterbänder können beispielsweise zur weiteren Verarbeitung mit Hilfe einer Seilwinde von den Spulen abgewickelt werden. Insbesondere kann der supraleitfähige Leiter bzw. das Kabel manuell oder motorisiert mit einer Seilwinde an einem geeigneten Seil durch die Vorrichtung bzw. Anlage gezogen werden.

In einer weiteren bevorzugten Ausführungsform ist die Stapelerzeugungseinrichtung ausgelegt, aus den ersten und zweiten leitfähigen Bändern einen Bandstapel mit kreuzförmigem Querschnitt zu bilden.

Insbesondere umfasst die Vorrichtung zur Herstellung eines supraleitfähigen Leiters:

- eine Band- oder Supraleiterbandbereitstellungseinrichtung zur Bereitstellung einer Vielzahl von ersten Supraleiterbändern, welche jeweils eine erste Breite aufweisen, und einer Vielzahl von zweiten Supraeiterbändern, welche jeweils eine zweite Breite aufweisen, wobei sich die erste Breite von der zweiten Breite unterscheidet;
- eine Belotungseinrichtung zum Aufbringen von flüssigem, d.h. heißem bzw. geschmolzenem, Lötmittel auf die ersten und zweiten Supraleiterbänder, d.h. zum Beloten der Supraleiterbänder;
- eine Stapelerzeugungseinrichtung zum Stapeln der mit flüssigem Lötmittel benetzten ersten und zweiten Supraleiterbänder, wobei die Stapelerzeugungseinrichtung ausgelegt ist, aus den ersten und zweiten Supraleiterbändern einen Bandstapel mit kreuzförmigem Querschnitt zu bilden;
- ein Walzensystem zum Bearbeiten des Bandstapels und Ausbilden eines Supraleiterkörpers.

In einer weiteren bevorzugten Ausführungsform umfasst die erfindungsgemäße Vorrichtung ferner eine Belotungsvorbereitungseinrichtung zum Reinigen und/oder zum Aufbringen von Flussmittel auf die leitfähigen Bänder, insbesondere auf die ersten und zweiten leitfähigen Bänder bzw. Supraleiterbänder. Vorzugsweise ist die Belotungsvorbereitungseinrichtung Teil der Bandbereitstellungseinrichtung. Mit anderen Worten umfasst die Bandbereitstellungseinrichtung die Belotungsvorbereitungseinrichtung. Mit Hilfe der Belotungsvorbereitungseinrichtung können die Bänder vorteilhafterweise von Verschmutzungen und/oder Oxidation befreit werden. Die Bänder laufen in der Belotungsvorbereitungseinrichtung durch mit Reinigungsmittel und/oder Flussmittel getränkten Schwämme der Belotungsvorbereitungseinrichtung und treten anschließend, vorzugsweise unmittelbar und insbesondere auf gleicher Höhe, in die Belotungseinrichtung bzw. in das Lötbad ein. Dabei ist der Abstand der Belotungsvorbereitungseinrichtung zur Belotungseinrichtung bzw. zum Lötbad minimal gewählt, so dass auch der Weg, auf dem eine erneute Oxidation erfolgen kann, minimal ist.

In einer weiteren bevorzugten Ausführungsform umfasst das Walzensystem eine Vielzahl von Walzeinheiten, wobei zumindest ein Teil der Walzeinheiten relativ zueinander verschoben und/oder verdreht werden können. Insbesondere können Profilwalzen der Walzeinheiten verdreht werden. Beispielsweise können die Walzeinheiten bzw. die Profilwalzen jeweils in diskreten Schritten, z.B. in 15°-Schritten, verdreht und fixiert werden. Mit anderen Worten kann für jede Walzeinheit ein bestimmter Verdrehwinkel eingestellt werden. Die Walzeinheiten sind insbesondere in multiplen Grad-Schritten verdrehbar. Somit kann eine Verdrillung direkt bei der Herstellung, d.h. noch im heißen Zustand, in den Bandstapel bzw. Supraleiterkörper eingebracht werden. Auf diese Weise kann eine Degradation auf Grund lokalen Stresses weitgehend vermieden werden.

Das Walzensystem ist vorzugsweise derart ausgelegt, dass die Abstände bzw. relativen Abstände zwischen den einzelnen Walzeinheiten einstellbar sind. Die Länge einer kompletten Verdrehung, d.h. die Schlaglänge oder der Twist-Pitch, kann durch Einstellen der Abstände zwischen den einzelnen Walzen bzw. Walzeinheiten und/oder durch Einstellen des Verdrehwinkels von Walzeinheit zu Walzeinheit festgelegt bzw. eingestellt werden. Mit anderen Worten kann die Schlaglänge des Leiters und/oder Bandstapels und/oder Supraleiterkörpers bzw. die Schlaglänge des Kabels über den Abstand bzw- über Abstände der einzelnen Walzeinheiten und/oder über den bzw. die relativen Verdrehwinkel der einzelnen Walzeinheiten eingestellt werden. Insbesondere ist das Walzensystem ausgelegt, die Schlaglänge des Leiters und/oder Bandstapels und/oder Supraleiterkörpers bzw. die Schlaglänge des Kabels über den relativen Abstand bzw. über relative Abstände der einzelnen Walzeinheiten und/oder über den oder die relativen Verdrehwinkel der einzelnen Walzeinheiten einzustellen. Jede Walzeinheit umfasst vorzugsweise eine Profilwalze, welche federnd gelagert ist.

Für den oben genannten weiteren unabhängigen Aspekt und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereit stellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann, und daher in Erwägung gezogen und auch als von der Beschreibung umfasst angesehen werden soll.

Kurze Beschreibung der Zeichnungen

| Figur 1 | zeigt ein schematisches Bild des Querschnittes eines beispielhaften mit dem erfindungsgemäßen Verfahren bzw. der erfindungsgemäßen Vorrichtung herstellbaren supraleitfähigen Leiters; |
|---|---|
| Figur 2a | zeigt ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters; |
| Figur 2b | zeigt ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters; |
| Figur 3 | zeigt eine schematische Skizze zu den Größenverhältnissen des kreuzförmigen Querschnitts eines beispielhaften, mit einer bevorzugten Ausführungsform des erfindungsgemäßen Verfahrens bzw. der erfindungsgemäßen Vorrichtung herstellbaren, supraleitfähigen Leiters; |
| Figur 4a | zeigt ein schematisches Bild des Querschnittes eines beispielhaften, mit einer bevorzugten Ausführungsform des erfindungsgemäßen Verfahrens bzw. der erfindungsgemäßen Vorrichtung herstellbaren, supraleitfähigen Leiters vor einem Kompaktieren; |
| Figur 4b | zeigt ein schematisches perspektivisches Bild des supraleitfähigen Leiters von Figur 4a; |
| Figur 5a | zeigt ein schematisches Bild des Querschnittes eines beispielhaften, mit einer bevorzugten Ausführungsform des erfindungsgemäßen Verfahrens bzw. der erfindungsgemäßen Vorrichtung herstellbaren, supraleitfähigen Leiters nach einem Kompaktieren; |
| Figur 5b | zeigt ein schematisches perspektivisches Bild des supraleitfähigen Leiters von Figur 5a; |
| Figur 6a | zeigt ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters vor einem Kompaktieren; |
| Figur 6b | zeigt ein schematisches perspektivisches Bild des supraleitfähigen Leiters von Figur 6a; |
| Figur 7a | zeigt ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters nach einem - Kompaktieren; |

Figur 7b          zeigt ein schematisches perspektivisches Bild des supraleitfähigen Leiters von Figur 7a;

Figuren 8a-8d     zeigen schematische Bilder von unterschiedlichen Anordnungen eines oder mehrerer beispielhaften, mit einer bevorzugten Ausführungsform des erfindungsgemäßen Verfahrens bzw. der erfindungsgemäßen Vorrichtung herstellbaren, supraleitfähigen Leiter zum Ausbilden eines Verbundes bzw. Kabels;

Figur 9a          zeigt ein schematisches Bild eines beispielhaften, mit einer bevorzugten Ausführungsform des erfindungsgemäßen Verfahrens bzw. der erfindungsgemäßen Vorrichtung herstellbaren in einer perspektivischen Ansicht;

Figur 9b          zeigt ein schematisches Bild eines beispielhaften, mit einer bevorzugten Ausführungsform des erfindungsgemäßen Verfahrens bzw. der erfindungsgemäßen Vorrichtung herstellbaren, supraleitfähigen Kabels in einer Querschnitts-Ansicht;

Figur 10a         zeigt eine schematische Zeichnung eines beispielhaften, mit einer bevorzugten Ausführungsform des erfindungsgemäßen Verfahrens bzw. der erfindungsgemäßen Vorrichtung herstellbaren, supraleitfähigen Leiters ohne Verdrillung;

Figur 10b         zeigt eine schematische Zeichnung eines beispielhaften, mit einer bevorzugten Ausführungsform des erfindungsgemäßen Verfahrens bzw. der erfindungsgemäßen Vorrichtung herstellbaren, supraleitfähigen Leiters mit Verdrillung;

Figur 11          zeigt eine schematische Skizze einer Vorrichtung zur Herstellung des erfindungsgemäßen supraleitfähigen Leiters gemäß einer bevorzugten Ausführungsform;

Figur 12          zeigt eine schematische Skizze einer Stapelerzeugungseinrichtung gemäß einer bevorzugten Ausführungsform der erfindungsgemäßen Vorrichtung in einer perspektivischen Ansicht;

Figur 13          zeigt schematische Schnittbilder von ausgewählten Teilen der Stapelerzeugungseinrichtung entlang der Linien P-Q, R-S und T-U der Figur 12;

Figur 14          zeigt ein schematisches Bild einer Walzeinheit gemäß einer bevorzugten Ausführungsform der erfindungsgemäßen Vorrichtung;

Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen.

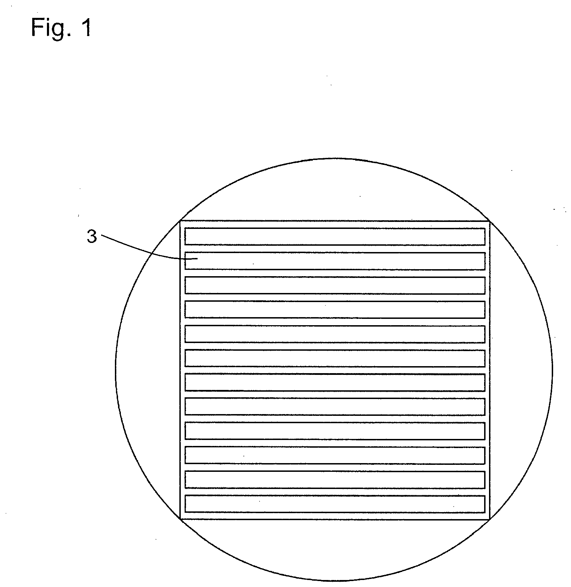

Die **Figur 1** zeigt ein schematisches Bild des Querschnittes eines beispielhaften, mit dem erfindungsgemäßen Verfahren bzw. der erfindungsgemäßen Vorrichtung herstellbaren, supraleitfähigen Leiters. Der Leiter umfasst mehrere leitfähige Bänder bzw. Supraleiterbänder 1, die jeweils dieselbe Breite aufweisen und aufeinandergestapelt sind. Der Querschnitt der aufeinandergestapelten Supraleiterbänder 1 ist quadratisch.

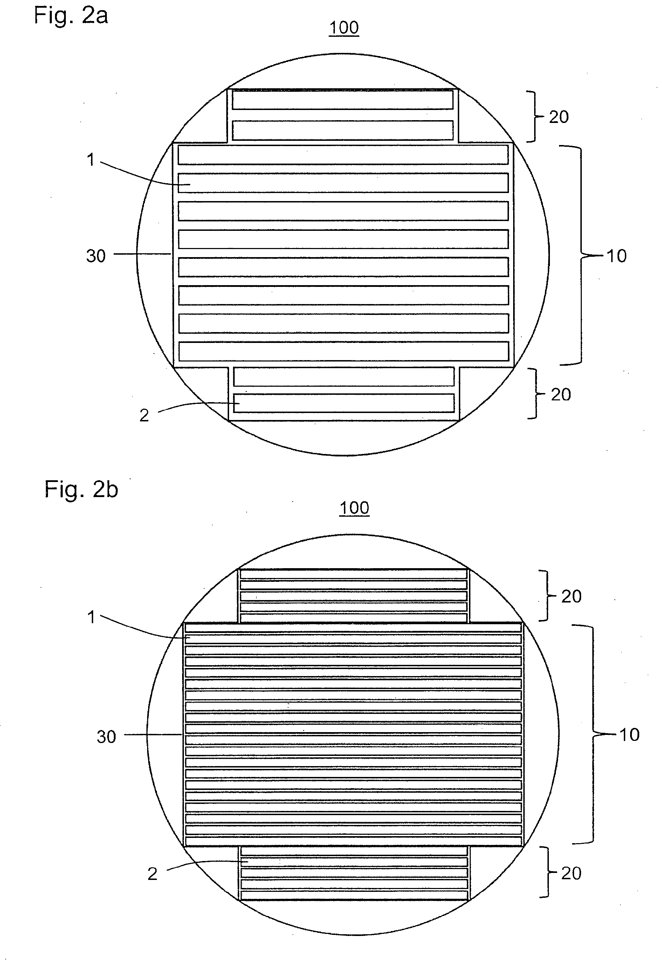

Die **Figuren 2a und 2b** zeigen jeweils ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters 100. Die **Figuren 2a und 2b** unterscheiden sich lediglich in der Anzahl der verwendeten leitfähigen Bänder bzw. Supraleiterbänder.

Im Folgenden werden der Einfachheit halber und ohne Beschränkung der Allgemeinheit nur supraleitfähige Leiter betrachtet, bei denen sämtliche leitfähige Bänder 1 bzw. 2 Supraleiterbänder sind.

Im Gegensatz zu dem Leiter 100 aus der **Figur 1** umfasst der Leiter 100 aus den **Figuren 2a und 2b** eine Vielzahl von ersten Supraleiterbändern 1 und eine Vielzahl von zweiten Supraleiterbändern 2. Die ersten Supraleiterbänder 1 weisen jeweils eine erste Breite und die zweiten Supraleiterbänder weisen jeweils eine zweite Breite auf, wobei die zweite Breite größer ist als die erste Breite. Der durch die Supraleiterbänder 1 und 2 gebildete Bandstapel 30 weist somit keinen quadratischen, sondern einen kreuzförmigen Querschnitt auf. Mit anderen Worten hat der Querschnitt des supraleitfähigen Leiters 100 die Form eines Kreuzes. Deshalb wird ein derartiger supraleitfähiger Leiter 100 auch als Kreuzleiter oder Cross Conductor (kurz CroCo) bezeichnet.

Der Bandstapel 30 kann in drei Abschnitte eingeteilt werden, nämlich in einen mittleren Abschnitt 10 und zwei Endabschnitte 20. Der mittlere Abschnitt 10, welcher zwischen den beiden Endabschnitten 20 angeordnet ist, umfasst ausschließlich erste Supraleiterbänder 1 und die beiden Endabschnitte 20 umfassen ausschließlich zweite Supraleiterbänder 2.

Der Kreuzleiter weist also Supraleiterbänder, insbesondere REBCO-Bänder, mit zwei unterschiedlichen Querschnitten bzw. Breiten auf. Somit kann der kreisförmige Querschnitt eines runden Leiters besser als in bisher realisierten Supraleiter-Stapeln ausgenutzt werden und gleichzeitig eine einfache Fertigung ermöglicht werden. Die Verwendung eines kreuzförmigen Supraleiter-Bandstapels anstelle eines quadratischen Supraleiter-Bandstapels bringt eine deutliche Verbesserung der Querschnittsnutzung. Während der geometrische Füllfaktor für den quadratischen Stapel aus der **Figur 1** nur 63,6% beträgt, beträgt der geometrische Füllfaktor im Falle des Bandstapels mit kreuzförmigem Querschnitt 78,4% (gerechnet für eine erste Breite von 6 mm und einer zweiten Breite von 4 mm). Durch die deutlich bessere Querschnittsausnutzung kann auch die Stromtragfähigkeit bzw. die Stromdichte des Leiters erhöht werden.

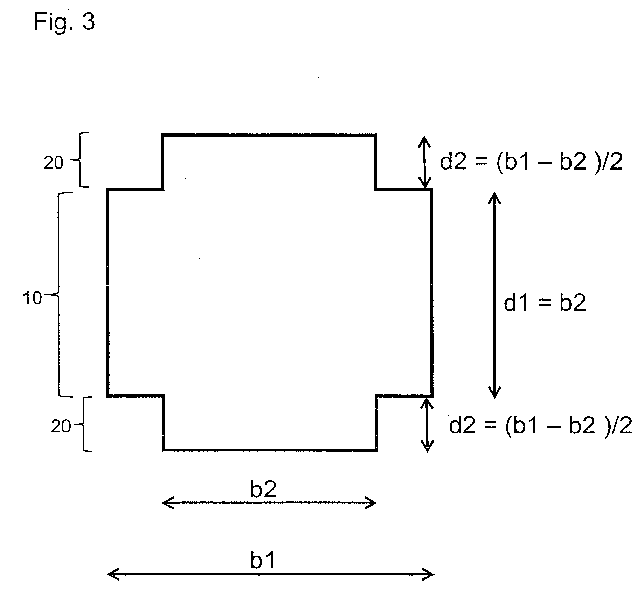

Die **Figur 3** zeigt eine schematische Skizze zu den Größenverhältnissen des kreuzförmigen Querschnitts eines beispielhaften, mit einer bevorzugten Ausführungsform des erfindungsgemäßen Verfahrens bzw. der erfindungsgemäßen Vorrichtung herstellbaren, supraleitfähigen Leiters. Um den Querschnitt möglichst gut auszunutzen, weist das Kreuz vierzählige Symmetrie auf, d.h. die Abmessungen des Kreuzes senkrecht zu den Bandflächen entsprechen den Breiten der Bänder. Der mittlere Abschnitt 10 des Bandstapels weist folglich eine Höhe $d_1$ auf, die im Wesentlichen der Breite $b_2$ der zweiten Supraleiterbänder 2 entspricht. Die Endabschnitte 20 weisen jeweils eine Breite $d_2$ auf, die im Wesentlichen der Hälfte der Differenz zwischen der Breite $b_1$ der ersten Supraleiterbänder 1 und der Breite $b_2$ der zweiten Supraleiterbänder 2 entspricht. Die Endabschnitte weisen also im Wesentlichen eine Höhe von

$$d_2 = (b_1 - b_2)/2 \qquad (2)$$

auf.

Für

$$b_2 = \frac{\sqrt{5}-1}{2} b_1 \approx 0{,}618 \cdot b_1 \quad (3)$$

ist das Flächenverhältnis aus Kreuzfläche zu Umkreisfläche maximal. In diesem Fall ergibt sich eine maximale Flächenfüllung von 78,7 %. Von den derzeit kommerziell auf dem Markt erhältlichen und geeigneten Supraleiterbändern kann dieses ideale Verhältnis am besten durch $b_1$ = 6 mm und $b_2$ = 4 mm, also $b_2/b_1$ = 0,667, angenähert werden. Damit ergibt sich eine maximale Flächenfüllung von 78,4 %, was nahezu dem theoretischen Maximum entspricht.

Ist die Breite $b_1$ der ersten Supraleiterbänder 6 mm und die Breite $b_2$ der zweiten Supraleiterbänder 4 mm, so ergibt sich für die Anzahl $N_1$ der ersten Supraleiterbänder in dem mittlerer Abschnitt 10 und die Anzahl $N_2$ der zweiten Supraleiterbänder in einem der Endabschnitte 20:

$$N_1 = 4 \text{ mm} / 0{,}165 \text{ mm} \approx 24 \qquad (4),$$

$$N_2 = (6 \text{ mm} - 4 \text{ mm}) / 0{,}165 \text{ mm} \approx 12 \qquad (5),$$

wenn 0,165 mm die Dicke der Supraleiterbänder ist. Die Dicke der Lotschicht wurde hierbei nicht berücksichtigt.

Beispielsweise können insgesamt 30 bis 36 Bänder, wobei jedes eine Stärke von ca. 150 bis 165 $\mu$m aufweist, für den Bandstapel verwendet werden. Dabei sind vorzugsweise zwei Drittel (also 20 bis 24) der Bänder 6 mm breit und ein Drittel der Bänder (also 10 bis 12) 4 mm breit. Unter Berücksichtigung der Dicke der Lotschichten zwischen den einzelnen Bändern ergibt sich damit eine Stärke des Kreuzleiters von etwa 5,5 mm bis 6,2 mm, also eine fast vierzählige Symmetrie der äußeren Form.

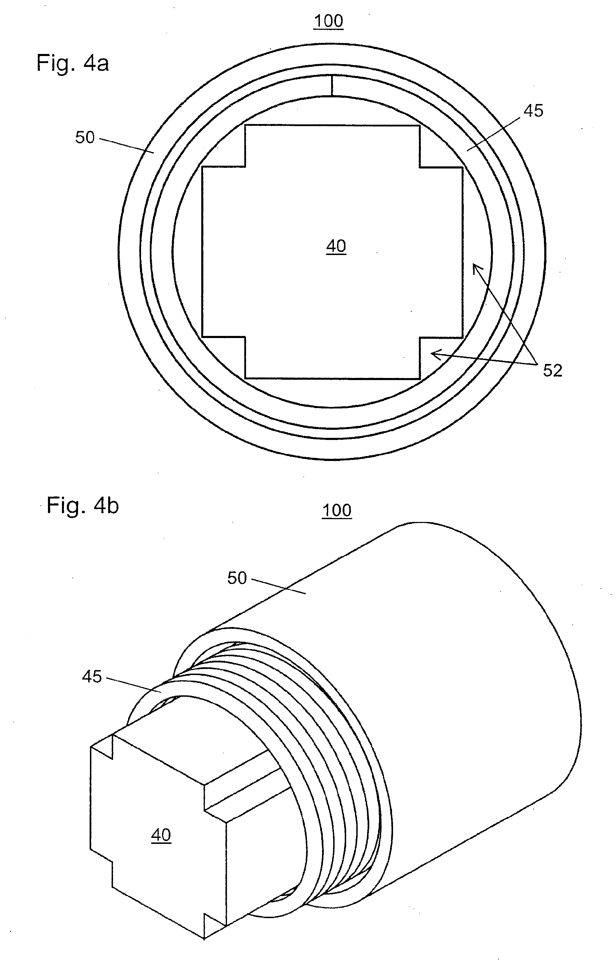

Die **Figuren 4a und 4b** zeigen jeweils ein schematisches Bild des Querschnittes eines weiteren beispielhaften, mit einer bevorzugten Ausführungsform des erfindungsgemäßen Verfahrens bzw. der erfindungsgemäßen Vorrichtung herstellbaren, supraleitfähigen Leiters 100, bevor der Leiter kompaktiert wurde. Dabei wurden zunächst der kreuzförmige Bandstapel bzw. die einzelnen Supraleiterbänder des Bandstapels zu einem Supraleiterkörper 40 verlötet und in ein rundes Hüllrohr 50 eingeführt, wobei der Supraleiterkörper 40 vor dem Einführen in das Hüllrohr 50 noch mit einem Lötdraht 45 umwickelt wurde.

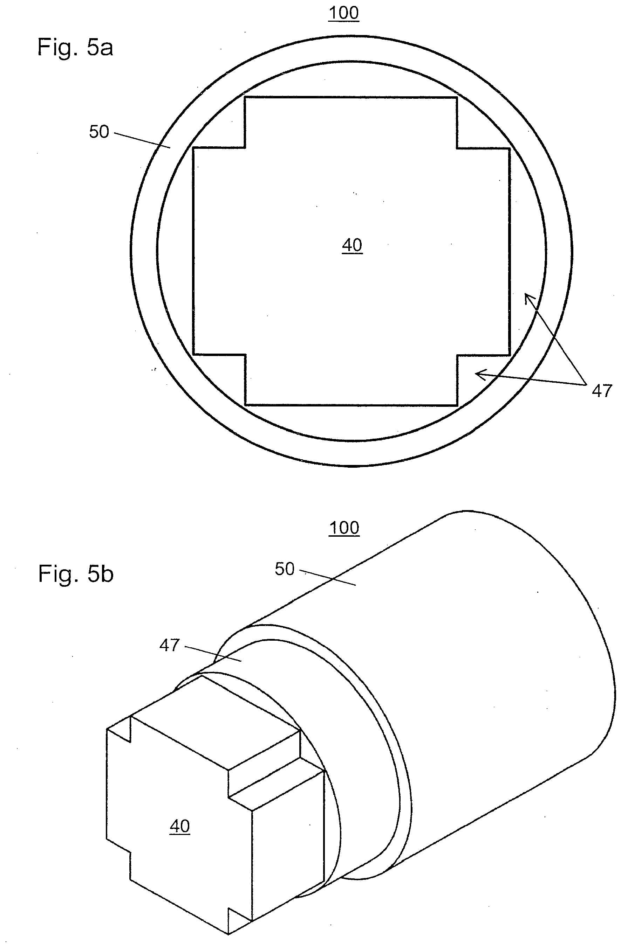

Die **Figuren 5a und 5b** zeigen jeweils ein schematisches Bild des supraleitfähigen Leiters 100, nachdem dieser über die Schmelztemperatur des Lötbandes 45 erwärmt und mit geeigneten Methoden, wie z.B. einem Rundkneten und/oder Hämmern, kompaktiert wurde. Wie in der **Figur 5a** und der perspektivischen Ansicht der **Figur 5b** zu erkennen ist, ist aus dem Lötdraht 45 der **Figur 4a bzw. 4b** durch das Erwärmen und/oder Kompaktieren eine ausgedehnte Lotschicht 47 zwischen Supraleiterkörper 40 und Hüllrohr 50 geworden.

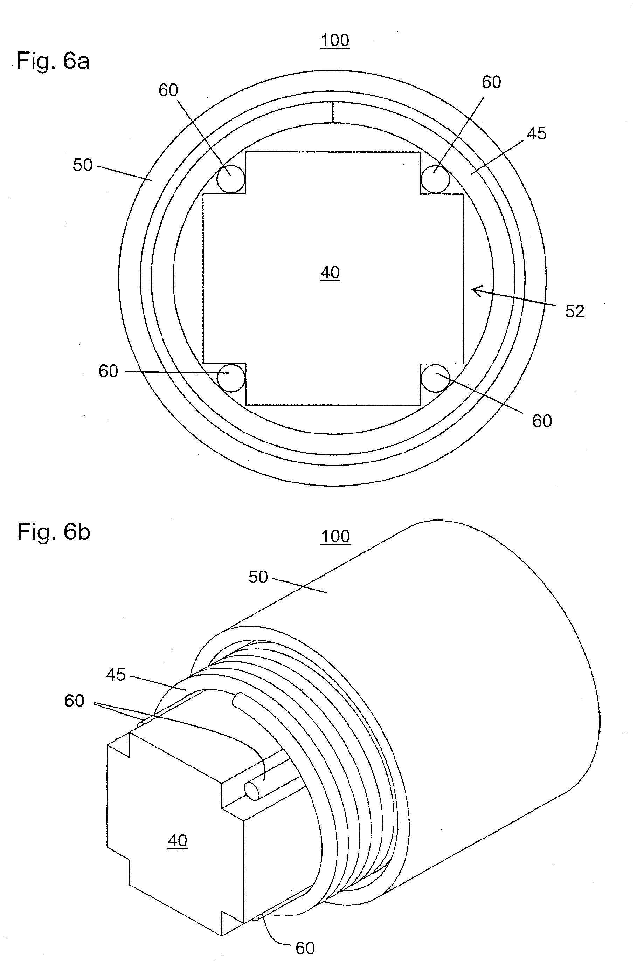

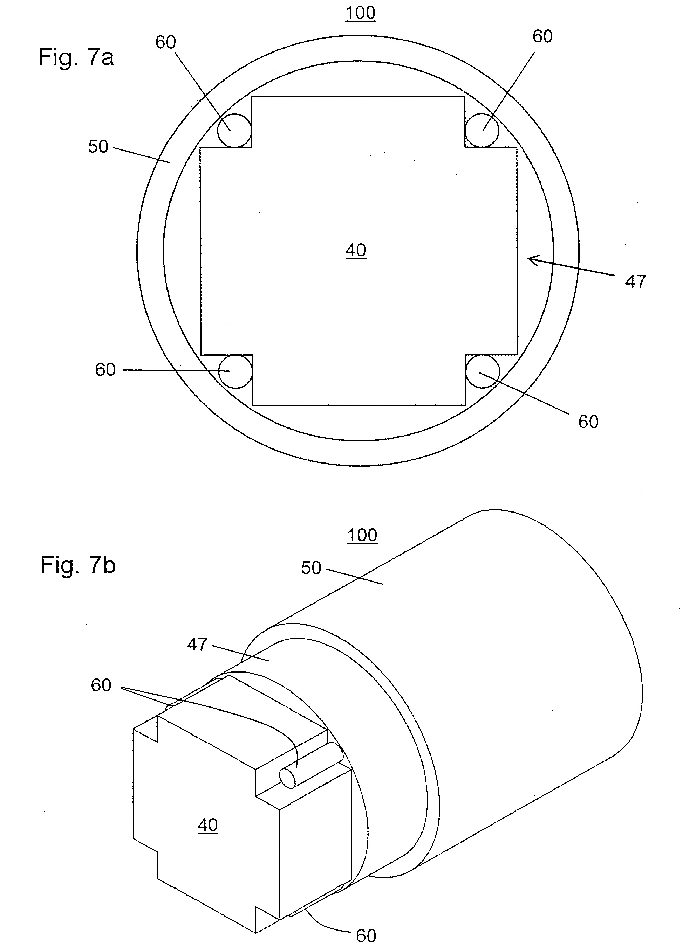

Die **Figuren 6a, 6b, 7a und 7b** entsprechen jeweils den **Figuren 4a, 4b, 5a und 5b** mit dem Unterschied, dass der supraleitfähige Leiter 100 in dem Beispiel der **Figuren 6a, 6b, 7a und 7b** zusätzliche Formstücke 60 umfasst, die zusammen mit dem Supraleiterkörper 40 in dem Hüllrohr 50 angeordnet bzw. in das Hüllrohr 50 eingeführt wurden. Auf diese Weise kann die Stabilität erhöht und Lötmittel eingespart werden.

Alternativ oder zusätzlich zu dem Lötdraht 45 kann der Supraleiterkörper 40 mit anderen bzw. weiteren Drähten oder Bänder, z.B. mit Metalldrähten aus Kupfer, Aluminium und/oder Messing, oder mit Stahldrähten, umwickelt werden. Solche zusätzlichen Drähte können die Stabilität und/oder die Leitfähigkeit, insbesondere in einem Quench-Fall, sicherstellen bzw. erhöhen.

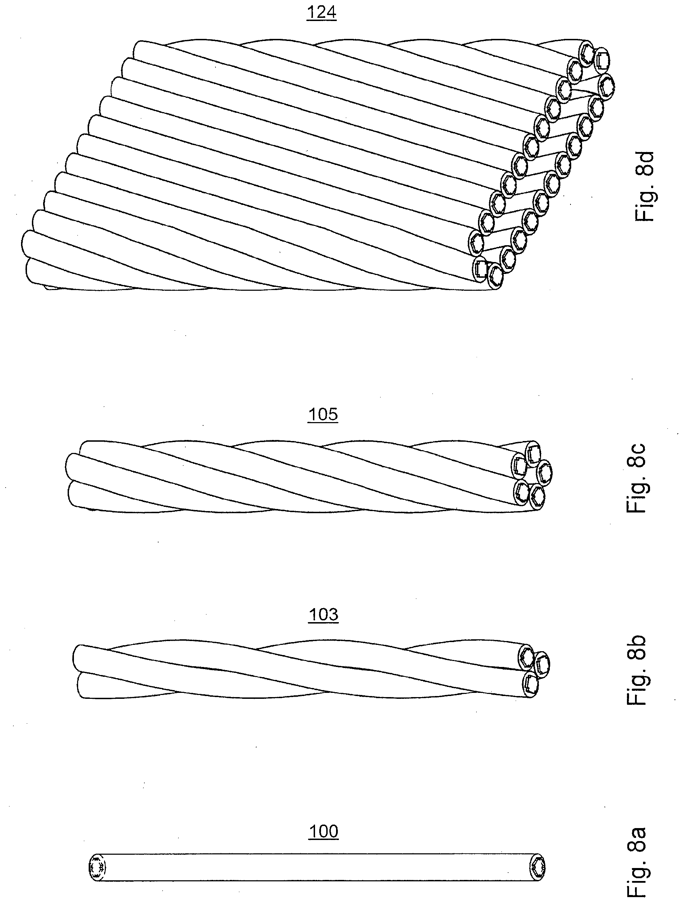

Die **Figuren 8a bis 8d** zeigen schematische Bilder von unterschiedlichen Anordnungen eines oder mehrerer beispielhaften, mit einer bevorzugten Ausführungsform des erfindungsgemäßen Verfahrens bzw. der erfindungsgemäßen Vorrichtung herstellbaren, supraleitfähigen Leiter 100, welche zu einem Verbund bzw. Kabel ausgebildet wurden. Der beispielhafte Kreuzleiter 100 kann, wie in der **Figur 8a** dargestellt, einzeln oder, wie in den **Figuren 8b bis 8d** dargestellt, als Kabel, insbesondere in verdrillten Verbünden benutzt werden, um die Stromtragfähigkeit je nach Anwendung zu erhöhen. In der **Figur 8b** ist beispielsweise ein Kabel 103 mit drei supraleitfähigen miteinander verdrillten Leitern 100 dargestellt, in der **Figur 8c** ist ein Kabel 105 mit fünf supraleitfähigen miteinander verdrillten Leitern 100 dargestellt und in der **Figur 8d** ist ein Kabel 124 mit 24 supraleitfähigen miteinander verdrillten Leitern 100 dargestellt.

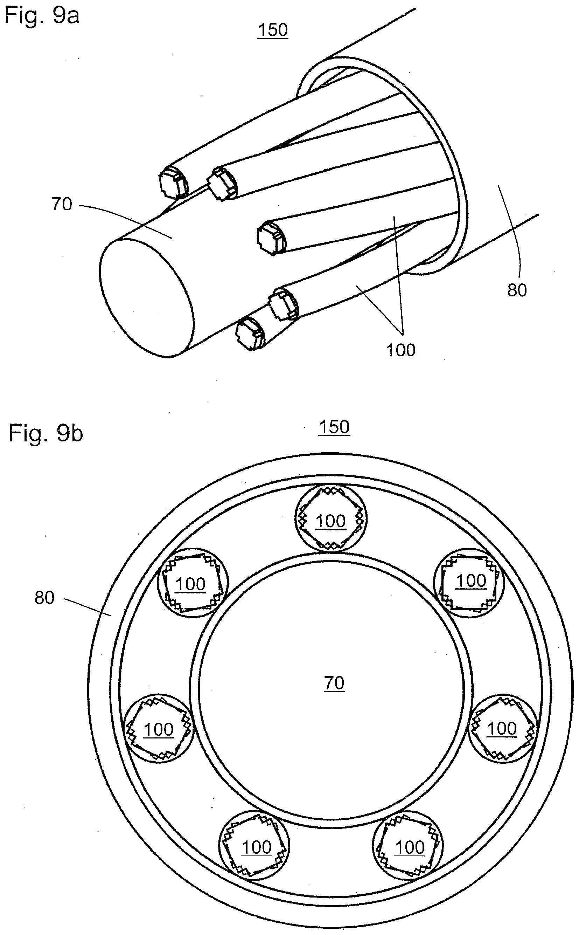

Wie in den **Figuren 9a und 9b** anhand eines Kabels 150 dargestellt, kann eine dem zu übertragenden Strom angepasste Anzahl an Leitern 100 um ein zentrales Rohr 70 oder einer geeigneten Halterung angeordnet werden, so dass das Streufeld der einzelnen Leiter 100 minimiert wird. Durch das Rohr 70 kann Kühlmittel gepumpt werden, um die Supraleiter zu kühlen. Zudem kann, wie in den **Figuren 9a und 9b** dargestellt, das Kabel 150 mit einen Schutzmantel 80, der vorzugsweise elektrisch isolierend ist, versehen werden.

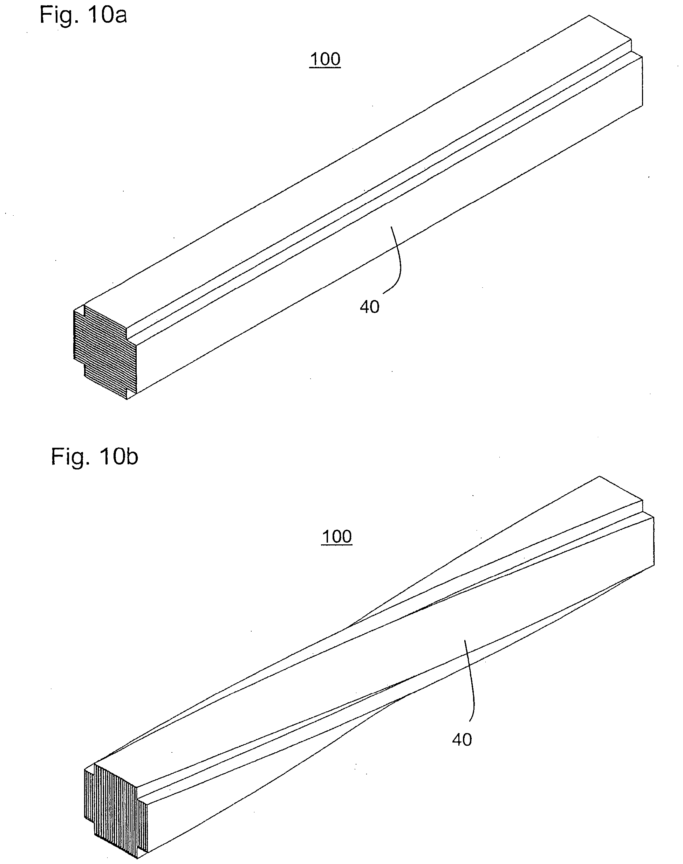

Die **Figur 10a** zeigt eine schematische Zeichnung eines beispielhaften, mit einer bevorzugten Ausführungsform des erfindungsgemäßen Verfahrens bzw. der erfindungsgemäßen Vorrichtung herstellbaren supraleitfähigen Leiters 100 ohne Verdrillung, während in der **Figur 10b** eine schematische Zeichnung eines beispielhaften, mit einer bevorzugten Ausführungsform des erfindungsgemäßen Verfahrens bzw. der erfindungsgemäßen Vorrichtung herstellbaren, supraleitfähigen Leiters 100 mit Verdrillung gezeigt ist.

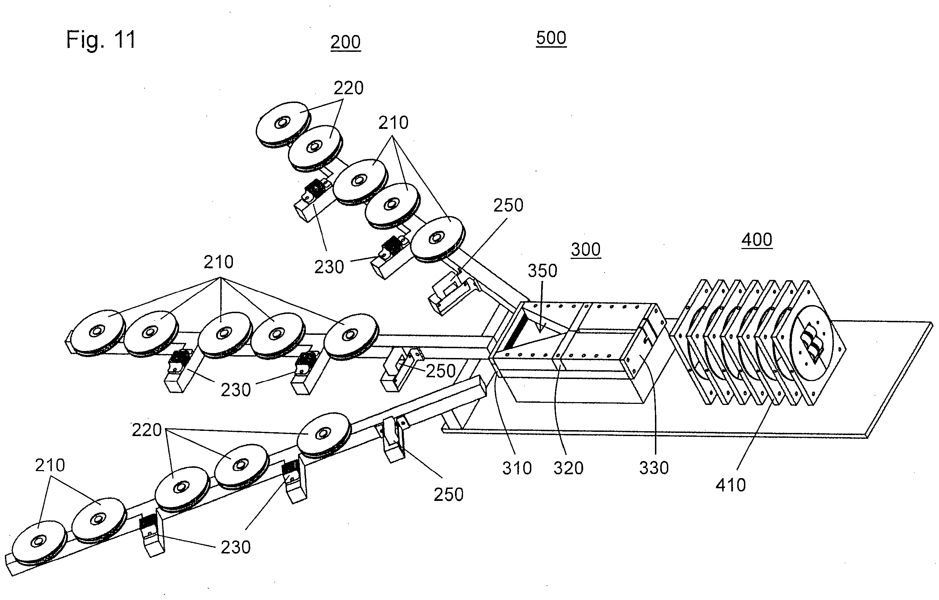

Die **Figur 11** zeigt eine schematische Skizze einer Vorrichtung 500 zur Herstellung des erfindungsgemäßen supraleitfähigen Leiters 100 gemäß einer bevorzugten Ausführungsform der vorliegenden Erfindung.

Die Vorrichtung 500 umfasst eine Bandbereitstellungseinrichtung 200, eine Belotungsvorbereitungseinrichtung 250, eine Stapelerzeugungseinrichtung 300, welche eine Belotungseinrichtung 350 umfasst, und ein Walzensystem 400.

Die Bandbereitstellungseinrichtung 200 umfasst eine Vielzahl von ersten Spulen 210 zum Bereitstellen von ersten Supraleiterbändern und eine Vielzahl von zweiten Spulen 220 zum Bereitstellen von zweiten Supraleiterbändern. Die Supraleiterbänder, welche der Einfachheit halber in der **Figur 11** nicht dargestellt sind, sind jeweils auf die Spulen 210 bzw. 220 aufgewickelt und werden mittels Führungs- bzw. Orientierungshilfen 230 der Belotungsvorbereitungseinrichtung 250 bzw. der Stapelerzeugungseinrichtung 300 zugeführt. Insbesondere können die Supraleiterbänder mit Hilfe einer Seilwinde (in der **Figur 11** nicht gezeigt) und einem geeigneten Seil, z.B. einem Stahlseil, von den Spulen 210 bzw. 220 abgewickelt und durch die Vorrichtung 500 gezogen werden.

Die Supraleiterbänder werden durch mit Reinigungs- und Lötflussmittel getränkten Schwämmen der Belotungsvorbereitungseinrichtung 250 von Verschmutzungen und/oder Oxidation befreit und für den Lötprozess vorbereitet. Anschließend werden sie in eine Belotungseinrichtung bzw. ein elektrisch beheizbares Lötbad 350 eingeführt.

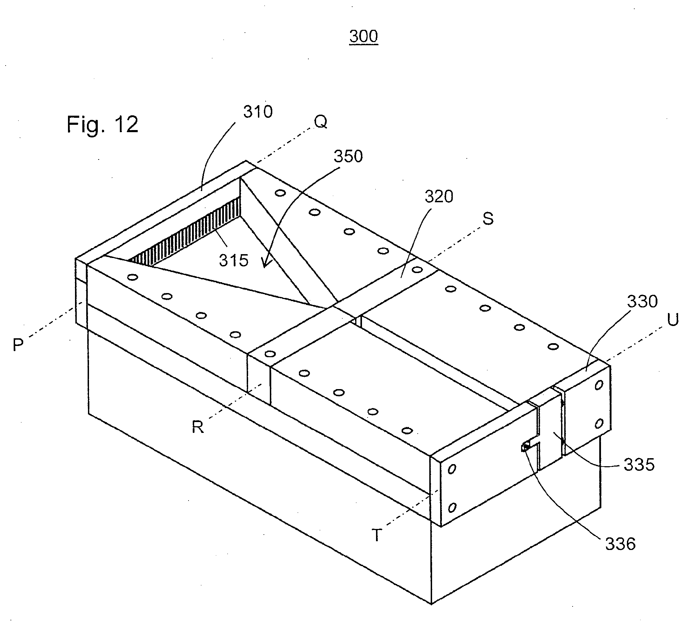

Eine schematische Skizze der Stapelerzeugungseinrichtung 300, welche als Lötbad 350 ausgebildet ist, ist nochmals im Detail in der **Figur 12** dargestellt. Die Stapelerzeugungseinrichtung 300 bzw. das Lötbad 350 umfasst einen Eingang 310, einen Durchgang 320 und einen Ausgang 330. Das Lötbad 350 ist aus Aluminium gebildet, da die meisten Lote Aluminium ohne spezielle Vorbehandlung nicht benetzen. Auf Grund der damit verbundenen großen Benetzungswinkel kann das Lot nicht durch einen dünnen Spalt (von ca. 0,3 mm Breite) fließen. Dies ermöglicht die Realisierung von Eingängen 315 des Lötbads 350 als einfache Schlitze in einem Aluminium-Quader.

Im Boden des Lötbades 350 befinden sich ein oder mehrere Heizpatronen (in den Figuren nicht gezeigt) mit einer Leistung, die zum Erwärmen des sich im Lötbad befindenden Lotes über die Schmelztemperatur des Lotes geeignet ist. Zudem befinden sich in einer hinteren Seitenwand des Lötbads 350 ein oder mehrere Thermoelemente (in den Figuren nicht gezeigt), über die die Temperatur des Lotes über einen Temperatur-Controller (in den Figuren nicht gezeigt) auf die gewünschte Temperatur gebracht wird. Die Lötbad-Temperatur wird derart gewählt, dass einerseits der Supraleiter nicht beschädigt wird. Andererseits muss die Lötbad-Temperatur deutlich über der Schmelztemperatur des Lötmittels liegen, damit die Temperatur des Lotes durch die durchlaufenden kalten Supraleiterbänder nicht unter die Schmelztemperatur absinkt. Im Fall von $Pb_{37}Sn_{63}$-Lot, das eine Schmelztemperatur von 183°C aufweist, ist dies für T - 230°C gewährleistet. Andere Lote bedingen andere Arbeitstemperaturen.

Für jedes Supraleiterband steht ein separater Eingang 315 in die Stapelerzeugungseinrichtung 300 bzw. in das Lötbad 350 zur Verfügung, so dass jedes Band beim Eintauchen in das Lot auf seiner gesamten Oberfläche mit Lot benetzt werden kann.

In der Mitte der Stapelerzeugungseinrichtung 300 bzw. des Lötbades 350 befindet sich ein der Geometrie angepasster Durchgang 320, an dem die sich noch vollständig in flüssigem Lot befindenden Einzelbänder zur Kreuzform zusammengeführt werden und gestapelt werden. Die Abmessungen des Durchgangs 320 sind etwas größer als die Abmessungen des zu bildenden bzw. gebildeten Bandstapels, so dass an dieser Stelle noch kein Druck auf die Bänder ausgeübt wird und diese lediglich zum angestrebten kreuzförmigen Querschnitt zusammengeführt werden.

Der Ausgang 330 der Stapelerzeugungseinrichtung 300 bzw. des Lötbads 350 umfasst eine federbelastete Schiebetür 335, wobei ein Negativ der Bandstapel-Form, z.B. ein Kreuz, in die Abschluss-Platte des Ausgangs 330 als Ausgangsöffnung 336 eingefräst ist. Damit wird zum einen eine hinreichende Dichtigkeit des Bades erreicht, zum anderen wird die Lotmenge zwischen den Bändern reduziert und die Form vorgegeben.

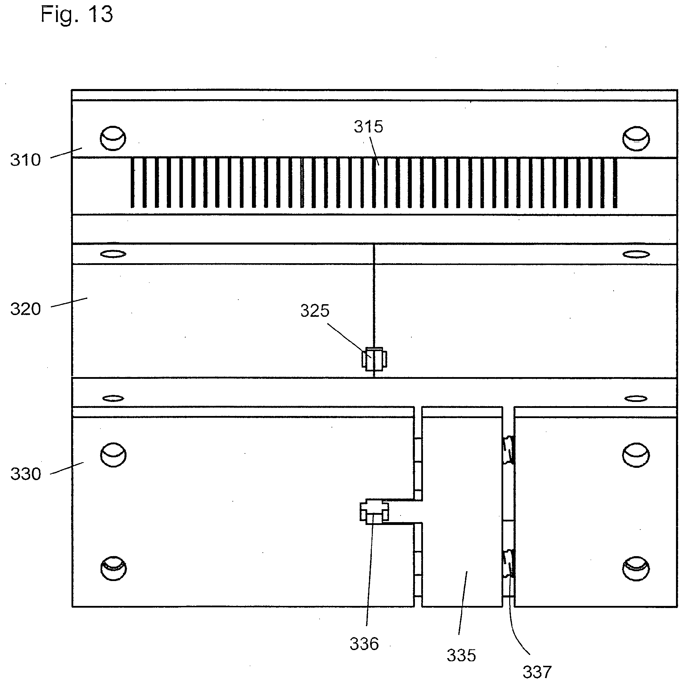

In der **Figur 13** sind nochmals schematische Schnittbilder von ausgewählten Teilen, nämlich dem Eingang 310, dem Durchgang 320 und dem Ausgang 330, der Stapelerzeugungseinrichtung 300 bzw. des Lötbads 350 entlang der Linien P-Q, R-S und T-U der **Figur 12** dargestellt. Es sind insbesondere die einzelnen kammartigen Eingänge 315 des Eingangs 310 für die Supraleiterbänder, eine Raum bzw. eine Öffnung 325 zur Erzeugung des Bandstapels in dem Durchgang 320, sowie eine Ausgangsöffnung 336 und eine mit Federn 337 belastete Schiebetür 335 in dem Ausgang 330 dargestellt.

In kurzer Distanz nach dem Ausgang 330 der Stapelerzeugungseinrichtung 300 bzw. des Lötbades 350 ist das Walzensystem 400, d.h. ein Press- und Torsionssystem, angeordnet, welches eine Vielzahl von Walzeinheiten 410 umfasst. Durch das Walzensystem 400 ist es möglich, in formschlüssiger Weise eine Verdrillung des kreuzförmigen Bandstapels bei noch flüssigem Lot zu realisieren.

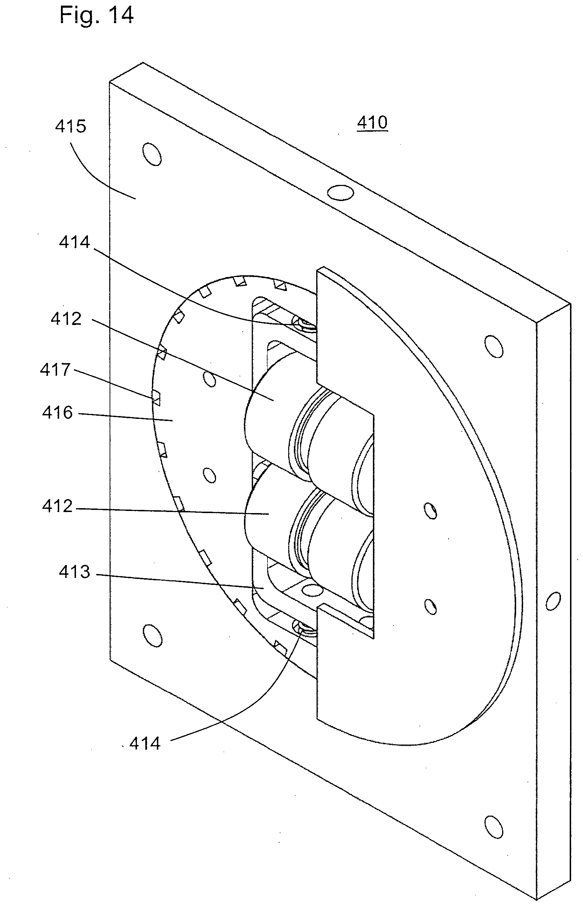

Die **Figur 14** zeigt ein schematisches Detailbild einer Presse bzw. Walzeinheit 410 gemäß einer bevorzugten Ausführungsform. Die Walzeinheit 410 umfasst einen Rahmen 415, in dem eine kreisförmige Halterung 416 in diskreten Schritten eingerastet und fixiert werden kann. Auf diese Weise kann die Walzeinheit 410 bzw. können Profilwalzen 412 der Walzeinheit 410 um eine Längsachse der Vorrichtung 500 verdreht werden. Somit kann eine Verdrillung des in Richtung der Längsachse durch die Walzen hindurchbewegten Bandstapels erzielt werden. Zwei in Bügeln 413 gehaltene Profilwalzen 412 sind über Federn 414 mit einer Aufnahme der Walzeinheit 410 verbunden. Abschlussplatten halten die Walzen 412 senkrecht zur Längs- bzw. Kabel-Achse in Position. Die Federn 414 stellen dabei einen konstanten Anpressdruck der Profilwalzen 412 auf den Bandstapel sicher, wobei die Federkonstante derart gewählt wird, dass die Pressung nicht zur Beschädigung der Bänder führt, aber auch den Formschluss der Profilwalzen 412 mit dem Bandstapel sicherstellt, und insbesondere ein "Durchrutschen" des Bandstapels verhindert.

Der Durchmesser der Walzen 412 kann z.B. 30 mm betragen. In die kreisförmige Halterung 416 sind z.B. 24 Einrastnuten 417 zum kontrollierten Verdrehen und Einrasten der Profilwalzen 412 eingefräst. Es versteht sich, dass der Durchmesser und die Zahl der Raststufen variiert werden kann. Durch Variation des Abstandes der Walzen bzw. Walzeinheiten 410 zueinander und durch Wahl geeigneter Drehwinkel (bzw. relativer Drehwinkel) benachbarter Walzen lässt sich die Schlaglänge der Verdrillung des supraleitfähigen Leiters gezielt einstellen.

Ein mit Hilfe des erfindungsgemäßen Verfahrens bzw. der erfindungsgemäßen Vorrichtung hergestellter supraleitfähiger Leiter weist neben hohen Stromdichten auch eine gute Stromverteilung sowie geringe Strom-Einkopplungslängen durch das gleichmäßige und zuverlässige Verlöten der Supraleiterbänder bzw. des Bandstapels in dem Lötbad auf. Durchgeführte Belastungs- bzw. Zugtests bei einer Temperatur von 4.2 K und einem Magnetfeld von 12 T zeigten, dass der Supraleiterkörper erst bei Belastungswerten zu degradieren beginnt, die mit denen der einzelnen Supraleiterbänder vergleichbar sind.

Das erfindungsgemäße Verfahren bzw. die erfindungsgemäße Vorrichtung zur Herstellung des supraleitfähigen Leiters zeichnet sich insbesondere durch eine hohe Flexibilität aus, indem durch den modularen Aufbau der Anlage zum Beispiel die Änderung der Schlaglänge durch einfaches Ändern des Walzenabstandes möglich ist. Eine Änderung des Querschnitts des Bandstapels (z.B. durch Verwendung anderer Breiten der HTS-Bänder oder anderer Geometrien) kann durch den Austausch der Profilwalzen und des Schiebeausgangs des Lötbades in kurzer Zeit realisiert werden. Auch ist eine schnelle und ökonomische Fertigung eines Bandstapels in anwendungsrelevanten Längen möglich. Der Supraleiterkörper kann mit Durchzugsgeschwindigkeiten von ca. 5 cm/s hergestellt werden, was im Vergleich zu herkömmlichen Verfahren eine deutliche Verbesserung hinsichtlich Geschwindigkeit bzw. Zeitersparnis darstellt. Zudem wird mit dem erfindungsgemäßen Verfahren bzw. der erfindungsgemäßen Vorrichtung eine einfache und ökonomische Fertigung durch die Vermeidung komplexer Teile, die nur individuell und mit hohem Aufwand und Kosten gefertigt werden können, bereitgestellt. Für die mit dem erfindungsgemäßen Verfahren bzw. der erfindungsgemäßen Vorrichtung herstellbaren supraleitfähigen Leiter sind insbesondere lediglich auf dem Markt erhältliche leitfähige Bänder bzw. Supraleiterbänder, Lötflussmittel, Lot und gegebenenfalls Metallfolien oder Bänder, Kupfer- oder andere Metallrohre in Standardgrößen notwendig.

**Bezugszeichenliste**

| | |
|---|---|
| 1 | Leitfähiges Band bzw. Supraleiterband |
| 2 | Leitfähiges Band bzw. Supraleiterband |
| 10 | Mittlerer Abschnitt |
| 20 | Endabschnitt |
| 30 | Bandstapel aus leitfähigen Bändern bzw. Supraleiterbändern |
| 40 | Supraleiterkörper |
| 45 | Lötdraht / Lötband |
| 47 | Lotschicht |
| 50 | Hüllrohr |
| 52 | Freiräume |
| 60 | Formstück |
| 70 | Rohr |
| 80 | Schutzmantel |
| 100 | Supraleitfähiger Leiter |
| 103 | Bündel von supraleitfähigen Leitern / Kabel |
| 105 | Bündel von supraleitfähigen Leitern / Kabel |
| 124 | Bündel von supraleitfähigen Leitern / Kabel |
| 150 | Bündel von supraleitfähigen Leitern / Kabel |
| 200 | Band- bzw. Supraleiterbandbereitstellungseinrichtung |
| 210 | Erste Spulen |
| 220 | Zweite Spulen |
| 230 | Führungs- bzw. Orientierungshilfen |
| 250 | Belotungsvorbereitungseinrichtung / Schwamm |
| 300 | Stapelerzeugungseinrichtung |
| 310 | Eingang |
| 315 | Einzeleingang |
| 320 | Durchgang |
| 325 | Raum / Öffnung zur Stapelbildung |
| 330 | Ausgang |
| 335 | Schiebetür |
| 336 | Ausgangsöffnung |
| 337 | Feder |
| 350 | Belotungseinrichtung / Lötbad |
| 400 | Walzensystem |
| 410 | Walzeinheit |
| 412 | Profilwalze |
| 413 | Bügel |
| 414 | Feder |
| 415 | Rahmen |
| 416 | Halterung |
| 417 | Nut / Einrastnut |
| 420 | Stahlseil |
| 500 | Vorrichtung / Anlage |

**Patentansprüche**

1. Verfahren zur Herstellung eines supraleitfähigen Leiters (100), umfassend die folgenden Schritte:

   - Bereitstellen einer Vielzahl von leitfähigen Bändern (1, 2) mit Hilfe einer Bandbereitstellungseinrichtung (200), wobei die Vielzahl von leitfähigen Bändern zumindest ein Supraleiterband umfasst;

- Aufbringen von flüssigem Lötmittel auf die Vielzahl von leitfähigen Bändern (1, 2) durch Eintauchen der leitfähigen Bänder (1, 2) in ein Lötbad (350);
- Ausbilden eines Bandstapels (30) durch Stapeln der mit Lötmittel benetzten leitfähigen Bänder (1, 2) in dem Lötbad (350);
- Ausbilden eines Supraleiterkörpers (40) durch Bearbeiten des Bandstapels (30) mit Hilfe eines Walzensystems (400);

wobei das Lötbad (350) einen Eingang (310) mit einer Vielzahl von kammartig angeordneten Einzeleingängen (315) für die Vielzahl von leitfähigen Bändern (1, 2), einen Durchgang (320) zum Stapeln der Vielzahl von leitfähigen Bändern (1, 2), und einen Ausgang (330) aufweist.

2. Verfahren nach Anspruch 1, wobei

das Bereitstellen einer Vielzahl von leitfähigen Bändern (1, 2) ein Bereitstellen einer Vielzahl von ersten leitfähigen Bändern (1), welche jeweils eine erste Breite aufweisen, und einer Vielzahl von zweiten leitfähigen Bändern (2), welche jeweils eine zweite Breite aufweisen, umfasst, wobei sich die erste Breite von der zweiten Breite unterscheidet, und wobei
das Stapeln der mit Lötmittel benetzten leitfähigen Bänder (1, 2) derart erfolgt, dass aus den ersten und zweiten leitfähigen Bändern (1, 2) ein Bandstapel (30) mit kreuzförmigem Querschnitt gebildet wird.

3. Verfahren nach Anspruch 1 oder 2, wobei das Verfahren vor dem Aufbringen von flüssigem Lötmittel umfasst:

- Reinigen der Vielzahl von leitfähigen Bändern (1, 2) und/oder
- Aufbringen von Flussmittel auf die Vielzahl von leitfähigen Bändern (1, 2) mit Hilfe einer Belotungsvorbereitungseinrichtung (250).

4. Verfahren nach einem der vorangehenden Ansprüche, wobei das Bearbeiten des Bandstapels (30) ein Verdrillen des Bandstapels (30) umfasst und zu einem Zeitpunkt erfolgt, zu dem das auf die leitfähigen Bänder (1, 2) aufgebrachte Lötmittel in einem flüssigen Zustand ist.

5. Verfahren nach einem der vorangehenden Ansprüche, ferner umfassend den Schritt:

- Einführen des Supraleiterkörpers (40) in ein Hüllrohr (50), wobei das Einführen des Supraleiterkörpers (40) in das Hüllrohr (50) vorzugsweise ein Integrieren von einem oder mehreren leitfähigen Formstücken (60) umfasst, wobei:

vor dem Einführen des Supraleiterkörpers (40) in das Hüllrohr (50) der Supraleiterkörper (40) mit Lot und/oder einem Metalldraht und/oder einem Stahlband und/oder einem Isoliermaterial umwickelt wird; und/oder wobei
vor dem Einführen des Supraleiterkörpers (40) in das Hüllrohr (50) der Supraleiterkörper (40) mit Lot umwickelt wird und anschließend der Supraleiterkörper (40) und/oder das Hüllrohr (50) zum mechanischen und/oder elektrischen Verbinden des Supraleiterkörpers (40) mit dem Hüllrohr (50) auf zumindest die Schmelztemperatur des Lotes erwärmt wird.

6. Verfahren nach Anspruch 5, ferner umfassend den Schritt:

- Kompaktieren des mit dem Supraleiterkörper (40) gefüllten Hüllrohres (50).

7. Vorrichtung (500) zur Herstellung eines supraleitfähigen Leiters (100), umfassend:

- eine Bandbereitstellungseinrichtung (200) zur Bereitstellung einer Vielzahl von leitfähigen Bändern (1, 2);
- ein Lötbad (350) zum Aufbringen von flüssigem Lötmittel auf die Vielzahl von leitfähigen Bändern (1, 2), in das die leitfähigen Bänder (1, 2) getaucht und mit Lötmittel benetzt werden können, wobei das Lötbad (350) ferner als Stapelerzeugungseinrichtung zum Ausbilden eines Bandstapels (30) durch Stapeln der mit flüssigem Lötmittel benetzten leitfähigen Bänder (1, 2) ausgelegt ist, und wobei das Lötbad (350) einen Eingang (310) mit einer Vielzahl von kammartig angeordneten Einzeleingängen (315) für die Vielzahl von leitfähigen Bändern (1, 2), einen Durchgang (320) zum Stapeln der Vielzahl von leitfähigen Bändern (1, 2), sowie einen Ausgang (330) aufweist;

- ein Walzensystem (400) zum Bearbeiten des Bandstapels (30) und Ausbilden eines Supraleiterkörpers (40).

8. Vorrichtung (500) nach Anspruch 7, wobei
die Bandbereitstellungseinrichtung (200) eine Vielzahl von ersten Spulen (210) zum Bereitstellen einer Vielzahl von ersten leitfähigen Bändern (1), welche jeweils eine erste Breite aufweisen und eine Vielzahl von zweiten Spulen (220) zum Bereitstellen einer Vielzahl von zweiten leitfähigen Bändern (2), welche jeweils eine zweite Breite aufweisen, umfasst, wobei sich die erste Breite von der zweiten Breite unterscheidet.

9. Vorrichtung (500) nach Anspruch 8, wobei
das Lötbad (300) ausgelegt ist, aus den ersten und zweiten leitfähigen Bändern (1, 2) einen Bandstapel (30) mit kreuzförmigem Querschnitt zu bilden.

10. Vorrichtung nach einem der Ansprüche 7 bis 9, ferner umfassend:

- eine Belotungsvorbereitungseinrichtung (250) zum Reinigen der leitfähigen Bänder (1, 2) und/oder zum Aufbringen von Flussmittel auf die leitfähigen Bänder (1, 2), wobei die Belotungsvorbereitungseinrichtung (250) vorzugsweise Teil der Bandbereitstellungseinrichtung (200) ist.

11. Vorrichtung nach Anspruch 10, wobei die Belotungsvorbereitungseinrichtung (250) einen oder mehrere Schwämme aufweist, die mit Reinigungsmittel und/oder Flussmittel getränkt sind.

12. Vorrichtung nach Anspruch 10 oder 11, wobei die Belotungsvorbereitungseinrichtung ausgelegt ist, die Bänder (1, 2) von Verschmutzungen und/oder Oxidation zumindest teilweise zu befreien.

13. Vorrichtung nach einem der Ansprüche 10 bis 12, wobei die Belotungsvorbereitungseinrichtung (250) derart angeordnet ist, dass die leitfähigen Bänder (1, 2) von der Belotungsvorbereitungseinrichtung (250) auf gleicher Höhe in die Belotungseinrichtung (350) eintreten können.

14. Vorrichtung nach einem der Ansprüche 7 bis 13, wobei das Walzensystem (400) eine Vielzahl von Walzeinheiten (410) umfasst, wobei zumindest ein Teil der Walzeinheiten (410) relativ zueinander verschoben und/oder verdreht werden kann.

15. Vorrichtung nach Anspruch 14, wobei das Walzensystem (400) ausgelegt ist, eine Schlaglänge des herzustellenden Leiters (100) über einen relativen Abstand der einzelnen Walzeinheiten (410) und/oder über einen relativen Verdrehwinkel der einzelnen Walzeinheiten (410) einzustellen.

**Claims**

1. Method for producing a superconductive conductor (100), comprising the following steps:

- providing a plurality of conductive strips (1, 2) by means of a strip provision device (200), wherein the plurality of conductive strips comprises at least one superconductor strip;
- applying liquid solder to the plurality of conductive strips (1, 2) by immersing the conductive strips (1, 2) in a solder bath (350);
- forming a strip stack (30) by stacking the conductive strips (1, 2) wetted with solder in the solder bath (350);
- forming a superconductor body (40) by processing the strip stack (30) with a roll system (400);

wherein the solder bath (350) comprises an inlet (310) with a plurality of individual inlets (315) arranged in a comb-like manner for the plurality of conductive strips (1, 2), a passage (320) for stacking the plurality of conductive strips (1, 2), and an outlet (330).

2. Method according to claim 1, wherein

providing a plurality of conductive strips (1, 2) involves providing a plurality of first conductive strips (1), each having a first width, and a plurality of second conductive strips (2), each having a second width, wherein the first width differs from the second width, and wherein
stacking the conductive strips (1, 2) wetted with solder takes place in such a way that a strip stack (30) having a cruciform cross-section is formed from the first and second conductive strips (1, 2).

3.  Method according to claim 1 or 2, wherein, before applying liquid solder, the method comprises:

    - cleaning the plurality of conductive strips (1, 2) and/or
    - applying flux to the plurality of conductive strips (1, 2) using a soldering preparation device (250).

4.  Method according to one of the preceding claims, wherein processing the strip stack (30) involves twisting the strip stack (30) and takes place at a time when the solder applied to the conductive strips (1, 2) is in a liquid state.

5.  Method according to one of the preceding claims, further comprising the following step:

    - inserting the superconductor body (40) into a sheath (50), wherein inserting the superconductor body (40) into the sheath (50) preferably includes integrating one or more conductive shaped pieces (60), wherein:

        before inserting the superconductor body (40) into the sheath (50), the superconductor body (40) is wrapped with solder and/or a metal wire and/or a steel strip and/or an insulating material; and/or wherein
        before inserting the superconductor body (40) into the sheath (50), the superconductor body (40) is wrapped with solder and subsequently the superconductor body (40) and/or the sheath (50) is heated at least to the melting temperature of the solder to mechanically and/or electrically connect the superconductor body (40) to the sheath (50).

6.  Method according to claim 5, further comprising the following step:

    - compacting the sheath (50) filled with the superconductor body (40).

7.  Apparatus (500) for producing a superconductive conductor (100), comprising:

    - a strip provision device (200) for providing a plurality of conductive strips (1, 2);
    - a solder bath (350) for applying liquid solder to the plurality of conductive strips (1, 2), in which bath the conductive strips (1, 2) can be immersed and wetted with solder, wherein the solder bath (350) is further configured as a stack producing device for forming a strip stack (30) by stacking the conductive strips (1, 2) wetted with liquid solder, and wherein the solder bath (350) has an inlet (310) with a plurality of individual inlets (315) arranged in a comb-like manner for the plurality of conductive strips (1, 2), a passage (320) for stacking the plurality of conductive strips (1, 2), and an outlet (330);
    - a roll system (400) for processing the strip stack (30) and forming a superconductor body (40).

8.  Apparatus (500) according to claim 7, wherein
    the strip provision device (200) comprises a plurality of first coils (210) for providing a plurality of first conductive strips (1), each having a first width, and a plurality of second coils (220) for providing a plurality of second conductive strips (2), each having a second width, wherein the first width differs from the second width.

9.  Apparatus (500) according to claim 8, wherein
    the solder bath (300) is configured to form a strip stack (30) having a cruciform cross-section from the first and second conductive strips (1, 2).

10. Apparatus according to one of claims 7 to 9, further comprising:

    - a soldering preparation device (250) for cleaning the conductive strips (1, 2) and/or for applying flux to the conductive strips (1, 2), wherein the soldering preparation device (250) is preferably part of the strip provision device (200).

11. Apparatus according to claim 10, wherein the soldering preparation device (250) has one or more sponges which are soaked with cleaning agent and/or flux.

12. Apparatus according to claim 10 or 11, wherein the soldering preparation device is configured to at least partially remove dirt and/or oxidation from the strips (1, 2).

**13.** The apparatus according to one of claims 10 to 12, wherein the soldering preparation device (250) is arranged in such a way that from the soldering preparation device (250) the conductive strips (1, 2) can enter the soldering device (350) at the same height.

**14.** Apparatus according to one of claims 7 to 13, wherein the roll system (400) comprises a plurality of roll units (410), wherein at least some of the roll units (410) can be displaced and/or rotated relative to one another.

**15.** Apparatus according to claim 14, wherein the roll system (400) is configured to set a lay length of the conductor (100) to be produced by means of a relative distance between the individual roll units (410) and/or by means of a relative rotation angle of the individual roll units (410).

**Revendications**

**1.** Procédé de fabrication d'un conducteur supraconducteur (100), comprenant les étapes suivantes :

- mise à disposition d'une pluralité de bandes conductrices (1, 2) à l'aide d'une installation de distribution de bande (200), la pluralité de bandes conductrices comprenant au moins une bande supraconductrice ;
- application de métal d'apport liquide sur la pluralité de bandes conductrices (1, 2) par immersion des bandes conductrices (1, 2) dans un bain de brasage (350) ;
- formation d'un empilement de bandes (30) par empilement des bandes conductrices (1, 2) couvertes de métal d'apport dans le bain de brasage (350) ;
- formation d'un corps supraconducteur (40) par façonnage de l'empilement de bandes (30) à l'aide d'un système de laminage (400) ;

le bain de brasage (350) présentant une entrée (310) dotée d'une pluralité d'entrées individuelles (315) disposées à la manière d'un peigne pour la pluralité de bandes conductrices (1, 2), un passage (320) pour l'empilement de la pluralité de bandes conductrices (1, 2) et une sortie (330).

**2.** Procédé selon la revendication 1, dans lequel

la mise à disposition de la pluralité de bandes conductrices (1, 2) comprend une mise à disposition d'une pluralité de premières bandes conductrices (1), qui présentent respectivement une première largeur, et d'une pluralité de secondes bandes conductrices (2), qui présentent respectivement une seconde largeur, la première largeur étant différente de la seconde largeur, et dans lequel l'empilement des bandes conductrices (1, 2) couvertes de métal d'apport est effectué de telle manière qu'un empilement de bandes (30) avec une section transversale en forme de croix est formé à partir des premières et secondes bandes conductrices (1, 2).

**3.** Procédé selon la revendication 1 ou 2, dans lequel le procédé comprend, avant l'application de métal d'apport liquide :

- un nettoyage de la pluralité de bandes conductrices (1, 2) et/ou
- une application de flux sur la pluralité de bandes conductrices (1, 2) à l'aide d'une installation de préparation au brasage (250).

**4.** Procédé selon l'une des revendications précédentes, dans lequel le façonnage de l'empilement de bandes (30) comprend un torsadage de l'empilement de bandes (30) et est effectué à un moment auquel le métal d'apport appliqué sur les bandes conductrices (1, 2) est dans un état liquide.

**5.** Procédé selon l'une des revendications précédentes, comprenant en outre l'étape :

- introduction du corps supraconducteur (40) dans un tube de gainage (50), l'introduction du corps supraconducteur (40) dans le tube de gainage (50) comprenant de préférence une intégration d'une ou plusieurs pièces moulées conductrices (60), dans lequel :
avant l'introduction du corps supraconducteur (40) dans le tube de gainage (50), du métal d'apport et/ou un fil métallique et/ou une bande d'acier et/ou un matériau isolant sont enroulés autour du corps supraconducteur (40) ; et/ou dans lequel avant l'introduction du corps supraconducteur (40) dans le tube de gainage (50), du métal d'apport est enroulé autour du corps supraconducteur (40), puis le corps supraconducteur (40) et/ou le tube de gainage (50) sont chauffés au moins à la température de fusion du métal d'apport pour la liaison mécanique et/ou électrique du corps supraconducteur (40) au tube de gainage (50).

6. Procédé selon la revendication 5, comprenant en outre l'étape :

   - compactage du tube de gaine (50) rempli du corps supraconducteur (40).

7. Dispositif (500) de fabrication d'un conducteur supraconducteur (100), comprenant :

   - une installation de distribution de bande (200) destinée à mettre à disposition une pluralité de bandes conductrices (1, 2) ;
   - un bain de brasage (350) destiné à appliquer du métal d'apport liquide sur la pluralité de bandes conductrices (1, 2) et dans lequel les bandes conductrices (1, 2) peuvent être immergées et couvertes de métal d'apport, le bain de brasage (350) étant en outre conçu sous la forme d'une installation de génération d'empilement destinée à la formation d'un empilement de bandes (30) par empilement des bandes conductrices (1, 2) couvertes de métal d'apport liquide, et le bain de brasage (350) présentant une entrée (310) dotée d'une pluralité d'entrées individuelles (315) disposées à la manière d'un peigne pour la pluralité de bandes conductrices (1, 2), un passage (320) pour l'empilement de la pluralité de bandes conductrices (1, 2), ainsi qu'une sortie (330) ;
   - un système de laminage (400) destiné à façonner l'empilement de bandes (30) et à former un corps supraconducteur (40).

8. Dispositif (500) selon la revendication 7, dans lequel l'installation de distribution de bande (200) comprend une pluralité de premières bobines (210) destinées à mettre à disposition une pluralité de premières bandes conductrices (1), qui présentent respectivement une première largeur, et une pluralité de secondes bobines (220) destinées à mettre à disposition une pluralité de secondes bandes conductrices (2), qui présentent respectivement une seconde largeur, la première largeur étant différente de la seconde largeur.

9. Dispositif (500) selon la revendication 8, dans lequel le bain de brasage (300) est conçu pour former un empilement de bandes (30) avec une section transversale en forme de croix à partir des premières et secondes bandes conductrices (1, 2).

10. Dispositif selon l'une des revendications 7 à 9, comprenant en outre :

    - une installation de préparation au brasage (250) destinée à nettoyer les bandes conductrices (1, 2) et/ou à appliquer du flux sur les bandes conductrices (1, 2), l'installation de préparation au brasage (250) faisant de préférence partie de l'installation de distribution de bande (200).

11. Dispositif selon la revendication 10, dans lequel l'installation de préparation au brasage (250) présente une ou plusieurs éponges qui sont imbibées de produit nettoyant et/ou de flux.

12. Dispositif selon la revendication 10 ou 11, dans lequel l'installation de préparation au brasage est conçue pour éliminer, au moins en partie, les salissures et/ou l'oxydation des bandes (1, 2).

13. Dispositif selon l'une des revendications 10 à 12, dans lequel l'installation de préparation au brasage (250) est disposée de telle manière que les bandes conductrices (1, 2) peuvent entrer dans l'installation de brasage (350) à la même hauteur depuis l'installation de préparation au brasage (250).

14. Dispositif selon l'une des revendications 7 à 13, dans lequel le système de laminage (400) comprend une pluralité d'unités de laminage (410), au moins une partie des unités de laminage (410) pouvant être déplacées et/ou tournées par rapport aux autres.

15. Dispositif selon la revendication 14, dans lequel le système de laminage (400) est conçu pour régler une longueur de pas du conducteur (100) à fabriquer par le biais d'un écart relatif entre les unités de laminage (410) individuelles et/ou par le biais d'un angle de rotation relatif des unités de laminage (410) individuelles.

## Fig. 1

Fig. 2a

Fig. 2b

Fig. 3

$d2 = (b1 - b2)/2$

$d1 = b2$

$d2 = (b1 - b2)/2$

b2

b1

Fig. 4a

Fig. 4b

Fig. 5a

100

50

40

47

Fig. 5b

100

50

47

40

Fig. 6a

100

60

60

50

45

40

52

60

60

Fig. 6b

100

50

45

60

40

60

Fig. 7a

Fig. 7b

124

Fig. 8d

105

Fig. 8c

103

Fig. 8b

100

Fig. 8a

Fig. 9a

150

70

80

100

Fig. 9b

150

80

100

100

100

100

70

100

100

100

Fig. 10a

100

40

Fig. 10b

100

40

Fig. 11

300

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- KR 1020070093702 A
- WO 2010042259 A
- JP 2010044969 A
- JP 2002270422 A
- US 5299728 A